# EUROPEAN PATENT APPLICATION

(11) **EP 2 249 630 A1**
(43) Date of publication of application: **10.11.2010**
(21) Application number: 08710907.0
(22) Date of filing: 07.02.2008
(51) Int. Cl.: H05K 1/02, B32B 15/08

(54) **CIRCUIT BOARD**

(71) Applicant: Sumitomo Bakelite Co., Ltd., Shinagawa-ku Tokyo 140-0002 (JP)
(72) Inventor: HASHIDO, Hiroaki, Tokyo 140-0002 (JP); MITOMI, Masatosi, Tokyo 140-0002 (JP)
(74) Representative: Schnappauf, Georg
(86) International application number: PCT/JP2008/052017
(87) International publication number: WO 2009/098765

(57) **Abstract**

Release papers (2A, 2B) are bonded to one face of a circuit board (1) via adhesive layers (3A, 3B), so as to cover the adhesive layers. The circuit board (1) is formed of a flexible multilayer board.

A nonadhesive portion (4) having no adhesive layers is formed on the portion of the circuit board face located between the adjacent release papers (2A, 2B), and pull-tabs (2Ap, 2Bp) for removing the respective release papers are formed at the end portions of the respective release papers (2A, 2B) located at the nonadhesive portion (4).

The pull-tabs are designed so as to face each other preferably at the adhesive portion (4), and the top end portions of the pull-tabs overlap with each other on the circuit board face. With this arrangement, it is possible to recognize the order of removing the respective release papers from the circuit board face.

## Description

### Technical Field

The present invention relates to a circuit board having adhesive layers covered with release papers.

### Background Art

In response to the recent demands for high-performance, light-weight thin electronic devices, high-density integration and high-density mounting of electronic components are being developed. In this trend, the semiconductor packages used for the electronic devices are becoming smaller than ever, and are having more pins. Accordingly, each circuit board (each printed wiring board) on which the above-mentioned semiconductor packages and the like are mounted is formed with more than one layer, and flexible multilayer circuit boards are often used as the circuit boards. Such a multilayer circuit board having the above-mentioned semiconductor packages mounted thereon is placed and secured in, for example, a thin housing with a small mounting space.

To place and secure the multilayer wiring board in the housing, a so-called screw securing method or an adhering method is employed. The latter, which is an adhering method, is for securing a wiring board in a housing by virtue of the viscoelasticity of an adhesive layer. Accordingly, the adhering method excels in shock resistance, compared with the former method, which is the screw securing method. Since the wiring board can be secured simply by pressing the appropriate portion of the wiring board against the inner wall or the like of the housing, the adhering method excels in workability in the mounting process.

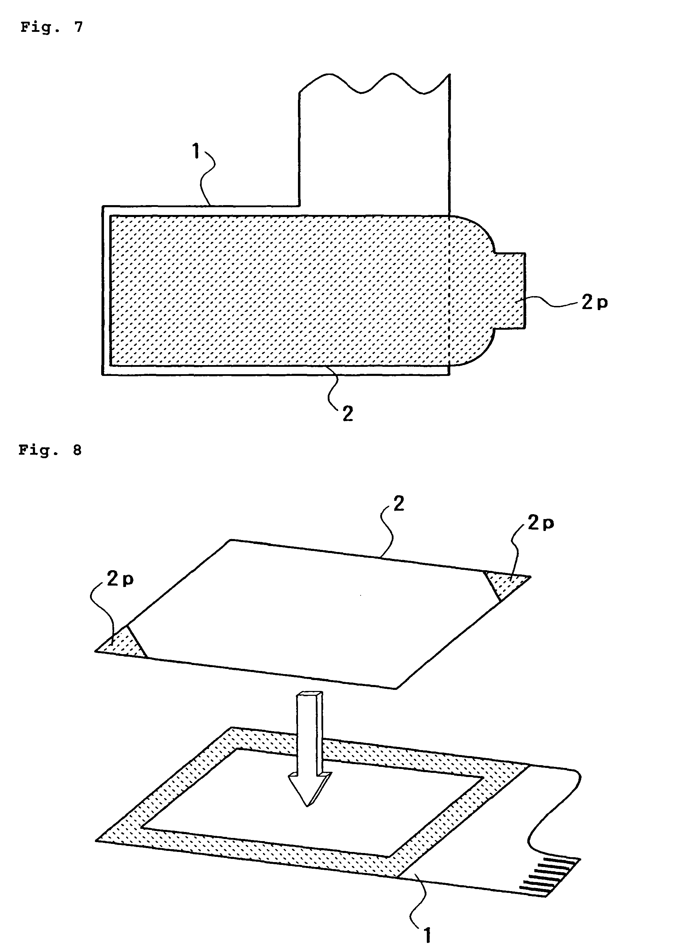

FIG. 7 illustrates an example of a flexible circuit board that secures a wiring board by a conventional adhering method. More specifically, in the example illustrated in FIG. 7, an adhesive layer (not shown) and a release paper 2 covering the adhesive layer are bonded to one face of a circuit board 1 formed into an L-shape. The end portion of the release paper 2 is designed to stick out of the circuit board 1, and function as a pull-tab 2p to be used for removing the release paper 2. Although not shown in the drawing, the multilayer circuit board 1 has appropriate electronic components mounted on a face other than the face to which the release paper 2 is bonded, or on the back side of the drawing.

Accordingly, in the circuit board 1 having the above-described structure, the release paper 2 is removed from the circuit board 1 by using the pull-tab 2p, and the adhesive layer remaining on the face of the circuit board 1 is pressed against the inner wall (not shown) of the housing or the like. In this manner, the circuit board 1 can be mounted in a predetermined position in the housing.

When a circuit board of this type is manufactured, a so-called multicavity technique is utilized to employ a large-size work board and divide the work board into two or more circuit boards in the end. In the circuit board having the structure illustrated in FIG. 7, however, the pull-tab 2p constituting part of the release paper 2 sticks out of the face of the circuit board 1, and the protruding portion is also regarded as part of the apparent circuit board. As a result, the number of circuit boards that can be obtained from a work board becomes smaller, which leads to cost increase.

To counter this problem, there is suggested a circuit board in which a release paper is bonded within a face of a circuit board, and two diagonal corners of the release paper are formed as pull-tabs, as shown in FIG. 8. More specifically, in the example illustrated in FIG. 8, the release paper 2 having a rectangular adhesive layer is bonded to one face (the upper face in the drawing) of a circuit board 1 or an electronic component. Two diagonal corners of the release paper 2 are designed to be nonadhesive portions 2p having no adhesive layers, and the nonadhesive portions 2p are used as pull-tabs.

With the structure illustrated in FIG. 8, the nonadhesive portions 2p functioning as pull-tabs are formed within a face of a circuit board or an electronic component. Accordingly, the problem with the structure illustrated in FIG. 7 can be solved. The structure of the circuit board illustrated in FIG. 8 is disclosed in Patent Document 1.
[Patent Document 1] Japanese Patent Application Laid-Open No. 2005-157012

Each of the structures illustrated in FIGS. 7 and 8 is designed as a structure in which a release paper is bonded to one face of a circuit board or the like. Therefore, in some products, it is preferable to bond two or more separate release papers to different locations on the circuit board face. In cases of such a structure, the following measures can be taken depending on the product: one of the release papers may be selectively removed while the other one is left, or the order of removing release paper may be determined based on the order of mounting the components and the like constituting the mechanism, for example.

### Disclosure of the Invention

### Problems to be Solved by the Invention

An object of the invention is to provide a circuit board that has plural separate release papers bonded to different locations on a circuit board face as described above, and has pull-tabs, placed at preferred locations, for selectively removing the respective release papers.

### Means for Solving the Problems

To solve the above problems, a circuit board having adhesive layers according to the present invention has a release paper bonded to at least one face of the circuit board via an adhesive layer, the release paper covering the adhesive layer, wherein a plurality of separated release papers is bonded to the one face of the circuit board, a nonadhesive portion without an adhesive layer is formed on a portion of the one face of the circuit board located between each two adjacent release papers, and pull-tabs for removing the respective release papers are formed at end portions of the respective release papers located at the nonadhesive portion.

In this case, the separated release papers are bonded, without sticking out of the one face of the circuit board. In addition, in a preferred embodiment, the pull-tabs for removing the respective release papers are designed to face each other at the nonadhesive portion. Furthermore, in one preferred example, top end portions of the pull-tabs are designed to overlap with each other on the one face of the circuit board.

In addition, indicators that indicate the order of removal may be provided on the release papers or on the pull-tabs for removing the release papers. The circuit board is preferably formed of a flexible multilayer board.

### Effects of the Invention

With the above-described structure of a circuit board, two or more release papers are separated and bonded at different locations on a circuit board face. Accordingly, in some products, one of the release papers may be selectively removed while the other one is left, and part of the circuit board may be bonded. Also, the order of removing release paper may be determined based on the order of mounting the components and the like constituting the mechanism, for example. In this manner, a structure can be flexibly mounted on a housing or the like including a circuit board.

The respective release papers are bonded to a face of a circuit board, without sticking out of the face, and a nonadhesive portion having no adhesive layers is formed on a portion of the circuit board face located between the adjacent release papers. With this arrangement, the pull-tabs for removing the respective release papers can be formed at the adjacent end portions of the respective release papers, so as to face each other.

In this case, the top end portions of the pull-tabs are designed to overlap with each other on the circuit board face, so that the order of removing the respective release papers is inevitably determined. Accordingly, the correct working sequence can be set. Furthermore, the indicators indicating the order of removal are provided on the pull-tabs or the release papers, so that the correct working sequence can be set.

### Brief Description of the Drawings

FIG. 1 is a top view showing an embodiment of a circuit board according to the present invention.
FIG. 2 is a perspective view showing an exemplary stack structure of the circuit board of FIG. 1.
FIG. 3 is a partially enlarged view showing another preferred example of the pull-tabs for removing the respective release papers.
FIG. 4 is a partially enlarged view showing still another preferred example of the pull-tabs.
FIG. 5 is a partially enlarged view showing yet another preferred example of the pull-tabs.
FIG. 6 is a partially enlarged view showing still yet another preferred example of the pull-tabs.
FIG. 7 is a top view showing an example of a conventional circuit board.
FIG. 8 is a perspective view showing another example of a conventional circuit board.

### Explanation of Reference Numerals

- 1: circuit board
- 2A, 2B: release paper
- 2Ap, 2Bp: pull-tab
- 2Am, 2Bm: indicator
- 3A, 3B: adhesive layer
- 4: nonadhesive portion
- 5: reinforcing plate

### Best Mode for Carrying Out the Invention

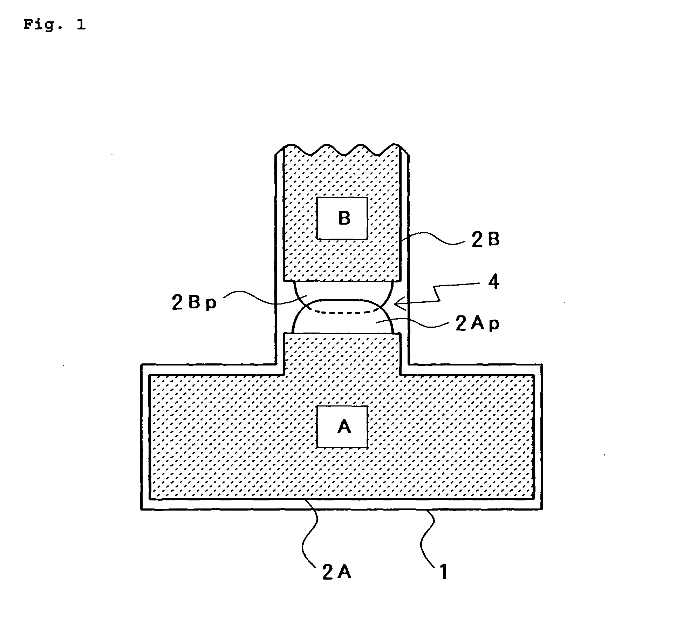

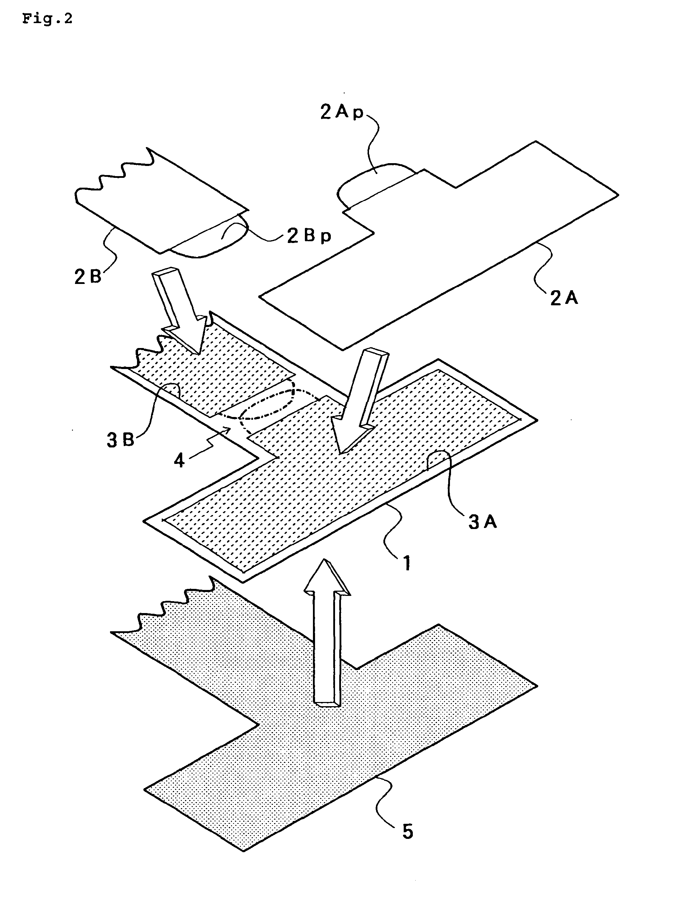

A circuit board according to the present invention will be described below with reference to an embodiment illustrated in the accompanying drawings. FIG. 1 is a top view of the fundamental structure of the circuit board. FIG. 2 is a perspective view of a preferred exemplary stack structure of the circuit board.

Reference numeral 1 denotes the circuit board. This circuit board 1 is formed into a T-shape as shown in the drawings, and is preferably a flexible multilayer board. Release papers are bonded to one face of the circuit board 1 via adhesive layers, and cover the adhesive layers. In the embodiment illustrated in the drawings, a release paper A (denoted by reference numeral 2A) and a release paper B (denoted by reference numeral 2B) are bonded to one face of the circuit board 1, so as not to stick out of the face of the circuit board 1.

The release papers A and B are bonded to the circuit board 1 via adhesive layers 3A and 3B illustrated with hatchings of broken lines in FIGS. 1 and 2. A nonadhesive portion 4 having no adhesive layers is formed at a location adjacent to the release papers A and B. The end portions of the release papers 2A and 2B located in the nonadhesive portion 4 are formed into circular arcs, and form pull-tabs 2Ap and 2Bp for removing the release papers 2A and 2B.

Therefore, in the embodiment illustrated in FIGS. 1 and 2, the pull-tabs 2Ap and 2Bp for removing the release papers 2A and 2B or A and B are formed to face each other at the nonadhesive portion 4, and the top end portions of the pull-tabs are designed to overlap with each other on the face of the circuit board 1. More specifically, in this embodiment, the pull-tab 2Bp of the release paper 2B is the lower one of the two pull-tabs, and the pull-tab 2Ap of the release paper 2A is the upper one as shown in FIG. 1.

With the above structure, the release paper 2A illustrated as A is removed first. Accordingly, as described in the paragraph of the "Effects of the Invention", the order of removing the release papers can be inevitably determined, and the correct sequence of operation can be set.

In the embodiment illustrated in the drawings, a reinforcing plate 5 having the same shape as the circuit board 1 is formed and stacked so as to line the circuit board 1, as shown in FIG. 2. In this manner, a composite board is formed. However, the reinforcing plate 5 is used when needed, and is not an essential component. Alternatively, the reinforcing plate 5 may be formed and stacked between the circuit board 1 and the adhesive layers 3A and 3B.

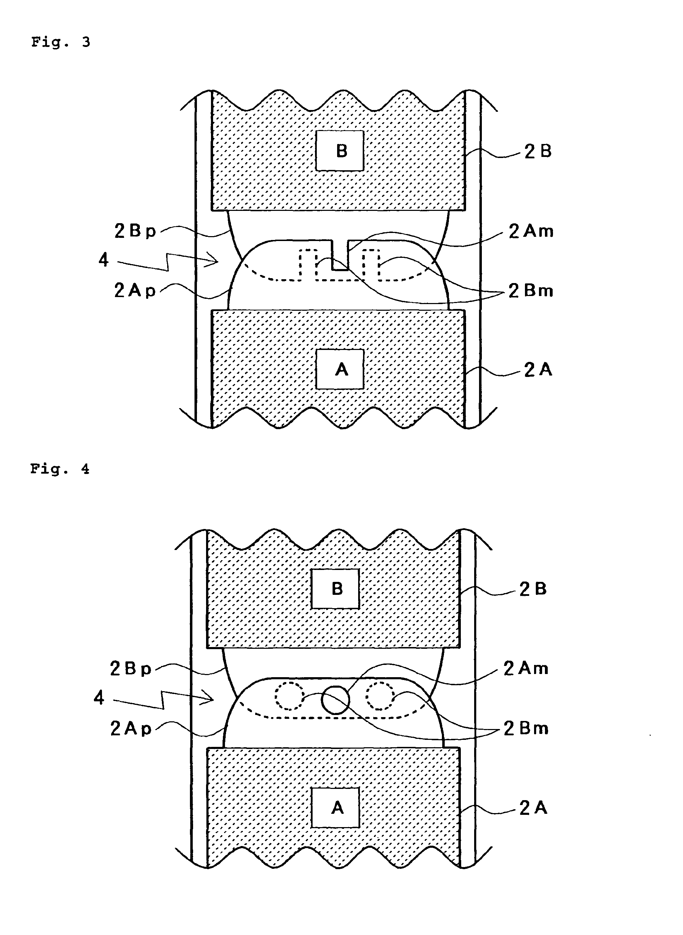

FIG. 3 is a diagram for explaining another preferred example of the pull-tabs 2Ap and 2Bp that are formed in the nonadhesive portion 4 to remove the release papers 2A and 2B. In the example illustrated in FIG. 3, the top end portions of the pull-tabs are designed to overlap with each other, as in the example illustrated in FIG. 1. The pull-tab 2Bp of the release paper 2B is the lower one of the pull-tabs, and the pull-tab 2Ap of the release paper 2A is stacked on the pull-tab 2Bp.

The pull-tabs 2Ap and 2Bp have indicators that indicate the order of removing the respective release papers 2A and 2B. In the example illustrated in FIG. 3, a notch 2Am is formed in the upper pull-tab 2Ap, and two notches 2Bm are formed in the lower pull-tab 2Bp. With this arrangement, it is possible to recognize that the release paper 2A having the one notch 2Am should be removed first, and the release paper 2B having the two notches 2Bm should be removed later.

In the structure illustrated in FIG. 3, even if the pull-tabs are overlapped the other way around during the operation to mount the board, the order of removing the respective release papers can be recognized from the number of notches formed in each of the pull-tabs 2Ap and 2Bp.

FIG. 4 is a diagram for explaining yet another preferred example of the pull-tabs 2Ap and 2Bp for removing the respective release papers 2A and 2B formed in the nonadhesive portion 4. In the example illustrated in FIG. 4, through holes are formed in the pull-tabs 2Ap and 2Bp, instead of the above-described notches. More specifically, one through hole 2Am is formed in the upper pull-tab 2Ap, and two through holes 2Bm are formed in the lower pull-tab 2Bp.

With this arrangement, it is possible to recognize that the release paper 2A having the one through hole 2Am formed therein is removed first, and the release paper 2B having the two through holes 2Bm formed therein is removed later. Accordingly, with the structure illustrated in FIG. 4, the same function effects as those in the example illustrated in FIG. 3 can be achieved.

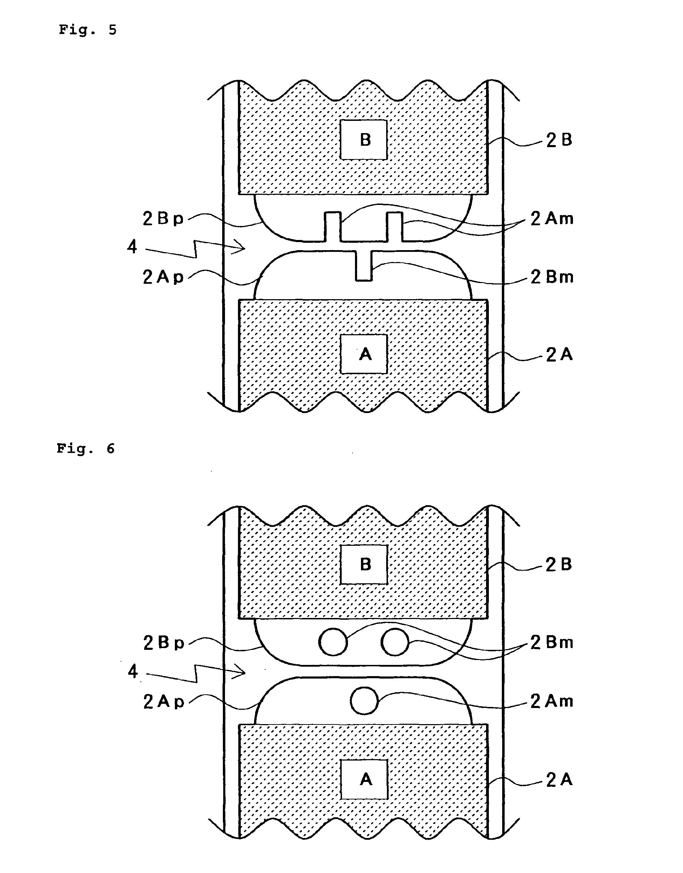

FIGS. 5 and 6 are diagrams for explaining other preferred examples of the pull-tabs 2Ap and 2Bp for removing the release papers 2A and 2B formed in the nonadhesive portion 4. In each of the examples illustrated in FIGS. 5 and 6, the respective pull-tabs 2Ap and 2Bp are designed not to overlap with each other in the nonadhesive portion 4, and the end portions of the respective pull-tabs face each other.

In the example illustrated in FIG. 5, different numbers of notches 2Am and 2Bm are formed on the pull-tabs facing each other. In the example illustrated in FIG. 6, different numbers of through holes 2Am and 2Bm are formed in the pull-tabs facing each other. Accordingly, it is possible to recognize the order of removing the respective release papers, according to the numbers of notches or through holes.

In the examples illustrated in FIGS. 3 to 6, indicators are provided in the form of notches or through holes formed in the pull-tabs. However, numerals or the like indicating the order of removal may be preferably printed on the pull-tabs or the release papers.

In the above-described embodiment, the two release papers 2A and 2B are bonded to a circuit board face, while being separated from each other. However, the number of separated release papers may be three or more, for example.

## Claims

1. A circuit board that has a release paper bonded to at least one face of the circuit board via an adhesive layer, the release paper covering the adhesive layer,
wherein a plurality of separated release papers is bonded to the one face of the circuit board, a nonadhesive portion without an adhesive layer is formed on a portion of the one face of the circuit board located between each two adjacent release papers, and pull-tabs for removing the respective release papers are formed at end portions of the respective release papers located at the nonadhesive portion.

2. The circuit board according to claim 1, wherein the separated release papers are bonded, without sticking out of the one face of the circuit board.

3. The circuit board according to claim 1 or 2, wherein the pull-tabs for removing the respective release papers are designed to face each other at the nonadhesive portion.

4. The circuit board according to claim 3, wherein top end portions of the pull-tabs are designed to overlap with each other on the one face of the circuit board.

5. The circuit board according to claim 1, wherein indicators that indicate the order of removal are provided on the release papers or on the pull-tabs for removing the release papers.

6. The circuit board according to claim 1, which is formed of a flexible multilayer board.
